# DEMANDE DE BREVET EUROPEEN

(11) **EP 4 317 932 A1**
(43) Date de publication de la demande: **07.02.2024**
(21) Numéro de dépôt: 23184642.9
(22) Date de dépôt: 11.07.2023
(51) Int. Cl.: G01M 3/04, G01M 15/14, G01M 3/18

(54) **PROCÉDÉ DE LOCALISATION D'UNE FUITE D'AIR DANS UN RÉSEAU D'ALIMENTATION EN AIR PRESSURISÉ, PRODUIT PROGRAMME D'ORDINATEUR ET SYSTÈME ASSOCIÉS**

(30) Priorité: 01.08.2022 FR 2207984
(71) Demandeur: Liebherr-Aerospace Toulouse SAS, 31016 Toulouse Cedex 2 (FR)
(72) Inventeur: DUCHAIGNE, Claire, 31016 TOULOUSE CEDEX 2 (FR)
(74) Mandataire: Bringer IP

(57) **Abrégé**

L'invention concerne un procédé de localisation d'une fuite d'air dans un réseau d'alimentation en air pressurisé comprenant une pluralité de composants et au moins une boucle (10) de détection de fuite comprenant une pluralité d'éléments (12a, 12b, 12c) sensibles, comprenant une étape de réception d'une information représentative d'une détection de la fuite par un élément sensible de ladite boucle de détection, une étape de réception d'un modèle 3D d'au moins une partie du réseau d'alimentation en air pressurisé, une étape d'interrogation d'une base de données associant un emplacement de fuite d'un composant à chaque localisation sur la boucle de détection, une étape de détermination d'une localisation précise de ladite fuite sur le réseau d'alimentation en air pressurisé, une étape de mise en correspondance de ladite localisation précise relativement à un composant, une étape d'instructions d'affichage du modèle 3D correspondant audit composant du réseau d'alimentation et de ladite localisation précise.

## Description

### Domaine technique de l'invention

L'invention concerne un procédé de localisation d'une fuite d'air dans un réseau d'alimentation en air pressurisé. En particulier, l'invention concerne un procédé permettant d'associer une localisation approximative d'une fuite d'air détectée par une boucle de détection à une location précise pouvant être mise en relation avec un modèle 3D du réseau d'alimentation.

### Arrière-plan technologique

Les réseaux d'alimentation en air pressurisé peuvent être installés notamment dans des véhicules, en particulier aéronautique ou ferroviaire, afin d'alimenter différents systèmes et dispositifs nécessitant de l'air pressurisé pour fonctionner.

Dans un aéronef, l'air pressurisé est notamment issu d'un prélèvement sur l'air moteur (l'air prélevé étant généralement appelé air *bleed*) ou généré par un compresseur dédié (dans les architectures de type *bleedless*), et est par exemple utilisé pour l'alimentation du système de conditionnement d'air, pour les systèmes anti-givrage, l'alimentation d'actionneurs, le démarrage ou redémarrage de moteurs propulsifs, etc.

Les réseaux d'alimentation en air pressurisé sont donc des éléments critiques qui doivent être supervisés, en particulier pour la détection de fuites qui peuvent par exemple endommager les équipements voisins de la fuite du fait de la chaleur de l'air pressurisé, et/ou réduire l'efficacité de l'alimentation en air pressurisé. Cette supervision s'effectue notamment par un système de détection de fuite d'air pressurisé, ou *Bleed Leak Détection System* en anglais qui comprend d'une part une protection isolante visant à contenir la fuite et des orifices disposés sur cette protection visant à diriger la fuite vers un élément sensible permettant la détection de la fuite. L'élément sensible fait partie d'un ensemble d'éléments sensibles connectés en série dans une boucle de détection de fuite, reliée à un contrôleur permettant d'interpréter les signaux générés par les éléments sensibles de la boucle et d'alerter sur la détection d'une fuite.

Actuellement, l'alerte donnée par le contrôleur est utilisé par un opérateur humain qui doit consulter une documentation technique papier pour mettre en lien le contenu de l'alerte avec l'équipement présentant la fuite. En particulier, des plans de la boucle de détection permettent de retrouver visuellement la position de l'élément sensible correspondant aux informations fournies par l'alerte, et la position de l'élément sensible doit être retrouvée visuellement sur un plan ou autre modélisation visuelle du réseau d'alimentation sur la documentation technique papier. La documentation technique papier est en outre généraliste et pas uniquement dédiée à la recherche de fuite ce qui complexifie sa consultation et la précision des informations permettant de détecter la fuite.

Les inventeurs ont donc cherché une solution permettant d'automatiser la détection de la localisation de la fuite afin de simplifier la maintenance de l'aéronef.

### Objectifs de l'invention

L'invention vise à fournir un procédé de localisation de fuite et un produit programme d'ordinateur pour la localisation de fuite dans un réseau d'alimentation en air pressurisé.

L'invention vise en particulier à fournir, dans au moins un mode de réalisation, un procédé de localisation de fuite dans un réseau d'alimentation en air pressurisé comprenant au moins une boucle de détection de fuite équipé d'éléments sensibles, en particulier dans un aéronef.

L'invention vise aussi à fournir, dans au moins un mode de réalisation de l'invention, un procédé de localisation permettant d'assister un opérateur à détection, la localisation et la maintenance ou la réparation d'une fuite d'un composant d'un réseau d'alimentation en air pressurisé.

L'invention vise aussi à fournir, dans au moins un mode de réalisation de l'invention, un procédé de localisation permettant d'assister un opérateur à détection, la localisation et la réparation d'une fuite d'un réseau d'alimentation en air pressurisé.

### Exposé de l'invention

Pour ce faire, l'invention concerne un procédé de localisation d'une fuite d'air dans un réseau d'alimentation en air pressurisé comprenant une pluralité de composants et au moins une boucle de détection de fuite comprenant une pluralité d'éléments sensibles, comprenant :
- une étape de réception d'une information représentative d'une détection de la fuite par un élément sensible de ladite boucle de détection, ladite information comprenant une référence à l'élément sensible ayant détecté la fuite et une localisation sur la boucle de détection,
- une étape de réception d'un modèle 3D d'au moins une partie du réseau d'alimentation en air pressurisé,
- une étape d'interrogation d'une base de données associant un emplacement de fuite d'un composant du réseau d'alimentation à chaque localisation sur la boucle de détection,
- une étape de détermination, à partir de ladite information représentative d'une détection et de ladite base de donnée, d'une localisation précise de ladite fuite sur le réseau d'alimentation en air pressurisé,
- une étape de mise en correspondance de ladite localisation précise relativement à un composant du réseau d'alimentation,
- une étape d'instructions d'affichage du modèle 3D correspondant audit composant du réseau d'alimentation et de ladite localisation précise.

Un procédé selon l'invention permet donc de simplifier la recherche de fuite par un opérateur grâce à la détermination automatisée d'une localisation précise de la fuite sur un modèle 3D du réseau d'alimentation en air pressurisé. La localisation est notamment facilitée par rapport à l'art antérieur où l'opérateur doit consulter manuellement une documentation technique papier exhaustive mais généralement non dédiée uniquement à la recherche de fuite. Le procédé de localisation est dédié à la recherche de fuite et permet de réduire le temps de recherche tout en augmentant la précision de la localisation de la fuite grâce à la base de données préremplie et le modèle 3D pré-généré.

L'affichage de la localisation précise sur un modèle 3D permet de simplifier la recherche de la fuite pour l'opérateur, notamment en permettant la manipulation du modèle (zoom, rotation, translation, vue totale ou partielle, etc.) pour repérer l'agencement du composant concerné en préparation de la maintenance ou réparation.

La réception de l'information représentative d'une détection de la fuite par un élément sensible de ladite boucle de détection peut être manuelle (par exemple entrée de l'information provenant du contrôleur par un opérateur humain dans une interface graphique) ou automatique (par exemple transmission directe de l'information par un contrôleur).

L'affichage du modèle 3D avec la localisation précise peut comprendre des informations complémentaires sur la maintenance ou la réparation de la panne, par exemple un historique de réparation, des instructions d'accès au composant à réparer, des tâches de réparation, etc.

Pour des raisons de redondance et de fiabilité, le réseau d'alimentation comprend généralement deux boucles de détection, gérées par le même contrôleur. Le procédé permet de distinguer la localisation de la panne en fonction de la ou les boucles de détection ayant détecté la fuite.

Avantageusement et selon l'invention, le procédé comprend une étape préliminaire de création de la base de données associant un emplacement de fuite d'un composant du réseau d'alimentation à chaque localisation sur la boucle de détection.

Avantageusement et selon l'invention, le procédé comprend une étape préliminaire de modélisation du modèle 3D, ledit modèle 3D comprenant des modèles 3D de composants du réseau d'alimentation et de la boucle de détection.

Selon ces aspects de l'invention, la création de la base de données et/ou du modèle 3D sont par exemple réalisées à partir de données existantes telles que la documentation technique existante et/ou des modèles 3D existants et sont adaptés à l'application particulière de la détection de fuite dans le réseau d'alimentation en air pressurisé.

Avantageusement et selon l'invention, l'étape préliminaire de modélisation du modèle 3D comprend la modélisation de colliers configurés pour l'attache de la boucle de détection au réseau d'alimentation.

Selon cet aspect de l'invention, la modélisation des colliers d'attache de la boucle de détection permet d'ajouter une information facilitant le repérage de la localisation de la fuite par l'opérateur lors de son intervention de réparation ou de maintenance.

Avantageusement et selon l'invention, la base de données comprend l'association entre la localisation sur la boucle de détection et chaque collier d'attache du réseau d'alimentation modélisé dans le modèle 3D.

Selon cet aspect de l'invention, l'ajout des colliers d'attache dans la base de données permet d'augmenter la précision lors de la détermination de la localisation précise en fonction des composants du réseau d'alimentation.

L'invention concerne également un produit programme d'ordinateur pour la localisation d'une fuite d'air dans un réseau d'alimentation en air pressurisé comprenant une pluralité de composants et au moins une boucle de détection de fuite comprenant une pluralité d'éléments sensibles, ledit produit programme d'ordinateur comprenant des instructions de code de programme pour l'exécution, lorsque ledit produit programme d'ordinateur est exécuté sur un ordinateur, des étapes suivantes :
- une étape de réception d'une information représentative d'une détection de la fuite par un élément sensible de ladite boucle de détection, ladite information comprenant une référence à l'élément sensible ayant détecté la fuite et une localisation sur la boucle de détection,
- une étape de réception d'un modèle 3D d'au moins une partie du réseau d'alimentation en air pressurisé,
- une étape d'interrogation d'une base de données associant un emplacement de fuite d'un composant du réseau d'alimentation à chaque localisation sur la boucle de détection,

- une étape de détermination, à partir de ladite information représentative d'une détection et de ladite base de donnée, d'une localisation précise de ladite fuite sur le réseau d'alimentation en air pressurisé,
- une étape de mise en correspondance de ladite localisation précise relativement à un composant du réseau d'alimentation,
- une étape d'instructions d'affichage du modèle 3D correspondant audit composant du réseau d'alimentation et de ladite localisation précise

Le produit programme d'ordinateur peut être exécuté par un dispositif informatique externe utilisé par les opérateurs de maintenance ou de réparation, en particulier un dispositif externe mobile telle qu'une mallette externe, ou bien par un dispositif informatique interne tel qu'un contrôleur de l'aéronef ou du véhicule comprenant le réseau d'alimentation en air pressurisé. Le dispositif informatique externe peut également par exemple être une tablette ou un téléphone, le produit programme d'ordinateur prenant la forme d'une application installée sur la tablette ou le téléphone.

Avantageusement et selon l'invention, le produit programme d'ordinateur de localisation de fuite selon l'invention comprend des instructions de code de programme pour l'exécution, lorsque ledit produit programme d'ordinateur est exécuté sur un ordinateur, des étapes du procédé de localisation de fuite selon l'invention.

Avantageusement et selon l'invention, le procédé de localisation de fuite selon l'invention est configuré pour être mis en oeuvre par un produit programme d'ordinateur de localisation de fuite selon l'invention.

L'invention concerne également un système de localisation d'une fuite d'air dans un réseau d'alimentation en air pressurisé comprenant une pluralité de composants et au moins une boucle de détection de fuite comprenant une pluralité d'éléments sensibles, comprenant :
- un module de réception d'une information représentative d'une détection de la fuite par un élément sensible de ladite boucle de détection, ladite information comprenant une référence à l'élément sensible ayant détecté la fuite et une localisation sur la boucle de détection,
- un module de réception d'un modèle 3D d'au moins une partie du réseau d'alimentation en air pressurisé,
- un module d'interrogation d'une base de données associant un emplacement de fuite d'un composant du réseau d'alimentation à chaque localisation sur la boucle de détection,
- un module de détermination, à partir de ladite information représentative d'une détection et de ladite base de donnée, d'une localisation précise de ladite fuite sur le réseau d'alimentation en air pressurisé,
- un module de mise en correspondance de ladite localisation précise relativement à un composant du réseau d'alimentation,
- un module d'instructions d'affichage du modèle 3D correspondant audit composant du réseau d'alimentation et de ladite localisation précise.

Un module peut par exemple consister en un dispositif informatique tel qu'un ordinateur, d'un ensemble de dispositifs informatiques, d'un composant électronique ou d'un ensemble de composants électroniques, ou par exemple d'un programme informatique, d'un ensemble de programmes informatiques, d'une librairie d'un programme informatique ou d'une fonction d'un programme informatique exécuté par un dispositif informatique tel qu'un ordinateur, un ensemble de dispositifs informatiques, un composant électronique ou un ensemble de composants électroniques.

Avantageusement et selon l'invention, le système de localisation de fuite selon l'invention est configuré pour mettre en oeuvre un procédé de localisation de fuite selon l'invention.

Avantageusement et selon l'invention, le procédé de localisation de fuite selon l'invention est configuré pour être mis en oeuvre par un système selon l'invention.

L'invention concerne également un procédé de localisation de fuite, un produit programme d'ordinateur de localisation de fuite et un système de localisation de fuite caractérisés en combinaison par tout ou partie des caractéristiques mentionnées ci-dessus ou ci-après.

### Liste des figures

D'autres buts, caractéristiques et avantages de l'invention apparaîtront à la lecture de la description suivante donnée à titre uniquement non limitatif et qui se réfère aux figures annexées dans lesquelles :
[Fig. 1] est une vue schématique d'une boucle de détection de fuite d'un réseau d'alimentation en air pressurisé,
[Fig. 2] est une vue schématique d'un ensemble de boucles de détection de fuite comprenant deux boucles de détection de fuite.
[Fig. 3] est une vue schématique d'un procédé de localisation de fuite selon un mode de réalisation de l'invention.
[Fig. 4] est une vue schématique d'un système de localisation de fuite selon un mode de réalisation de l'invention.

### Description détaillée d'un mode de réalisation de l'invention

Sur les figures, les échelles et les proportions ne sont pas strictement respectées et ce, à des fins d'illustration et de clarté.

En outre, les éléments identiques, similaires ou analogues sont désignés par les mêmes références dans toutes les figures.

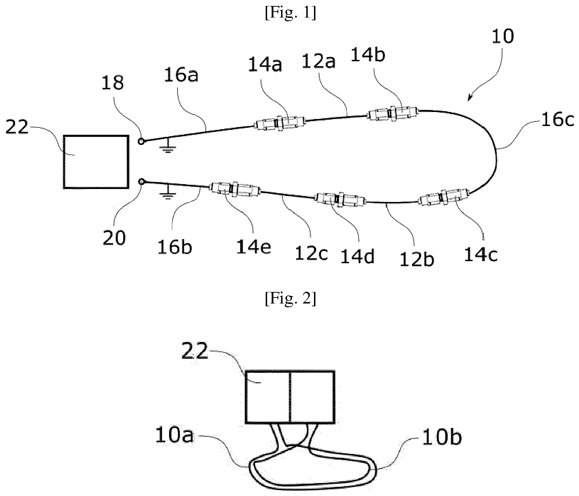

La figure 1 représente schématiquement une boucle 10 de détection de fuite dans un réseau d'alimentation en air pressurisé. La boucle comprend une pluralité d'éléments 12a, 12b, 12c sensibles et des fils 16a, 16b, 16c de connexion reliés entre eux par des connecteurs 14a, 14b, 14c, 14d, 14e. Les éléments 12a, 12b, 12c sensibles permettent la détection des fuites tandis que les fils 16a, 16b, 16c de connexion permettent la transmission l'énergie électrique dans l'ensemble de la boucle. Les éléments 12a, 12b, 12c sensibles sont par exemple formés d'éléments conducteurs dont une partie entre en fusion lors de la détection d'une fuite ce qui entraîne la formation d'un point de contact dans l'élément sensible et ainsi le passage d'électricité.

La boucle est également définie par un point 18 de début de boucle et un point 20 de fin de boucle, lesdits points étant reliés à un contrôleur 22 du véhicule permettant l'alimentation en énergie et l'interprétation des changements d'états de la boucle, notamment en cas de détection d'une fuite au niveau d'un élément sensible. Dans un aéronef, le contrôleur 22 est par exemple le contrôleur de détection de fuite et anti-givrage AILC pour *anti-ice and leak détection controller* en anglais.

La détection d'une fuite par un élément sensible est détectée par le contrôleur 22 qui interprète l'information reçue et la restitue, généralement sous la forme d'une information représentative d'une détection de la fuite par un élément sensible. Cette information peut par exemple comprendre, dans ce mode de réalisation, la dénomination de l'élément sensible ayant détecté la fuite ainsi qu'une valeur exprimant de façon linéaire, exprimée en pourcentage, la localisation de la fuite sur la boucle de détection par rapport à aux points de début et de fin de boucle, 0% exprimant une fuite au niveau du point 18 de début de boucle, 100% exprimant une fuite au niveau du point 20 de fin de boucle, 50% exprimant une fuite au niveau d'un point sur la boucle équidistant des points de début et de fin de boucle. Dans la documentation technique papier de l'art antérieur, des intervalles de pourcentage sont associés à chaque élément sensible, par exemple et uniquement à but illustratif 30% à 40% pour un premier élément 12a sensible, 55% à 65% pour un deuxième élément 12b sensible et 65% à 75% pour un troisième élément 12c sensible.

La figure 2 représente schématiquement un ensemble de deux boucles de détection de fuite, une première boucle 10a de détection de fuite et une deuxième boucle 10b de détection de fuite, les deux boucles étant reliées au contrôleur 22 et suivant le même parcours de sorte à fournir une redondance et une fiabilité dans la détection de fuite, notamment pour garantir la détection de fuite et réduire le nombre de fausses détections de fuite.

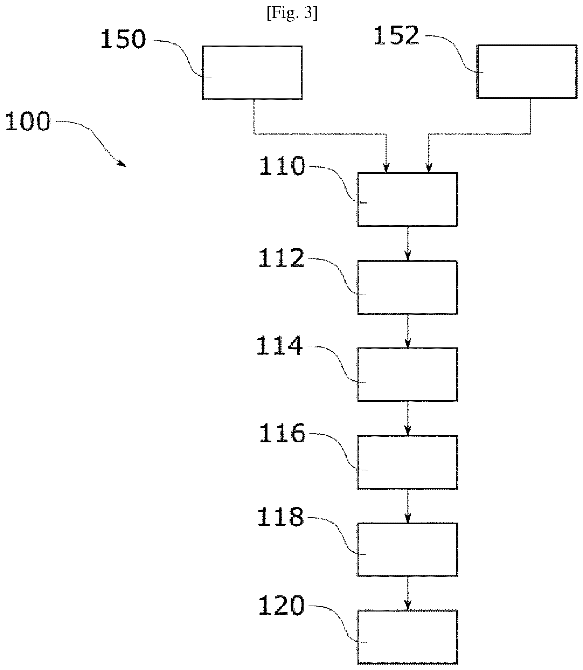

La figure 3 représente schématiquement un procédé 100 de localisation de fuite selon l'invention.

Le procédé permet la localisation d'une fuite d'air dans un réseau d'alimentation en air pressurisé comprenant une pluralité de composants et au moins une boucle de détection de fuite comprenant une pluralité d'éléments sensibles.

Le procédé 100 de localisation de fuite comprend notamment une étape 110 de réception d'une information représentative d'une détection de la fuite par un élément sensible de ladite boucle de détection, ladite information comprenant une référence à l'élément sensible ayant détecté la fuite et une localisation sur la boucle de détection. Dans ce mode de réalisation, comme décrit précédemment, l'information comprend l'élément sensible ayant détecté la fuite et un pourcentage indiquant la localisation de la fuite sur la boucle de détection par rapport aux points de début et de fin de boucle.

Lorsque le procédé est mis en oeuvre par un produit programme d'ordinateur, le produit programme d'ordinateur peut soit recevoir l'information représentative d'une détection de la fuite directement du contrôleur 22, ou bien nécessiter que l'information représentative d'une détection de la fuite soit fournie manuellement par un opérateur de maintenance ou de réparation dans le produit programme d'ordinateur, via une interface graphique.

Le procédé 100 de localisation de fuite comprend également une étape 112 de réception d'un modèle 3D d'au moins une partie du réseau d'alimentation en air pressurisé. Le modèle 3D est par exemple préparé lors d'une étape 150 préliminaire de modélisation du modèle 3D, ledit modèle 3D comprenant des modèles 3D de composants du réseau d'alimentation et de la boucle de détection.

Le procédé 100 de localisation de fuite comprend ensuite une étape 114 d'interrogation d'une base de données associant un emplacement de fuite d'un composant du réseau d'alimentation à chaque localisation sur la boucle de détection, et une étape 116 de détermination, à partir de ladite information représentative d'une détection et de ladite base de donnée, d'une localisation précise de ladite fuite sur le réseau d'alimentation en air pressurisé.

Dans ce mode de réalisation, la base de données fait notamment le lien entre une localisation précise de la fuite et l'élément sensible ayant détecté la fuite ainsi que le pourcentage représentant la localisation. Ces étapes permettent de passer d'une localisation uniquement liée à l'élément sensible et la boucle à une localisation liée au réseau d'alimentation en lui-même, où la fuite est présente, tout en prenant compte du pourcentage exact fourni représentant la localisation. En particulier, le pourcentage permet de connaître exactement la localisation de la fuite sur la boucle de détection de fuite, alors que l'art antérieur ne fournissait que des intervalles de pourcentage pour chaque élément sensible. Ces étapes remplacent la consultation par un opérateur de la documentation technique papier d'une part pour trouver l'information associant à chaque élément sensible un intervalle de pourcentage, et d'autre part pour trouver l'information associant à cette localisation dans la boucle à une localisation précise dans le réseau d'alimentation, sur la base d'une estimation mentale approximative effectuée par l'opérateur sur la base du pourcentage fourni. Par exemple, pour la boucle de détection de la figure 1, un pourcentage de 62% associé au deuxième élément 12b sensible ne pourra pas être précisément localisé dans la documentation papier, mais pourra être associé à une localisation précise dans le procédé de localisation 100 de l'invention grâce à la base de données.

La base de données peut être préparée lors d'une étape 152 préliminaire de création de la base de données associant un emplacement de fuite d'un composant du réseau d'alimentation à chaque localisation sur la boucle de détection.

Le procédé 100 de localisation de fuite comprend également une étape 118 de mise en correspondance de ladite localisation précise relativement à un composant du réseau d'alimentation, permettant d'identifier le composant du réseau d'alimentation présentant une fuite.

Le procédé 100 de localisation de fuite comprend enfin une étape 120 d'instructions d'affichage du modèle 3D correspondant audit composant du réseau d'alimentation et de ladite localisation précise. L'opérateur de maintenance ou de réparation peut ainsi connaître le composant nécessitant l'intervention et ainsi préparer son intervention sur la base de la localisation précise et le composant concerné. En outre, l'opérateur peut permettre d'identifier directement le lieu d'intervention, ce qui accélère et simplifie la réparation ou la maintenance.

L'affichage peut consister en l'affichage d'un point lumineux, fixe ou clignotant, sur une vue globale ou partielle du réseau d'alimentation, représentant la localisation précise. L'affichage peut également comprendre des options de navigation 3D tels que translation, rotation ou zoom du modèle 3D, et la présence d'un texte éditable relatif au composant du réseau d'alimentation, à des instructions permettant la réparation et de maintenance, à un historique du composant, à des commentaires d'opérateurs ayant intervenu précédemment sur le composant ou sur d'autres composants voisins du réseau d'alimentation, etc.

L'affichage peut également être configuré selon les besoins de l'opérateur.

Dans un mode de réalisation de l'invention, l'étape 150 préliminaire de modélisation du modèle 3D comprend notamment la modélisation de colliers configurés pour l'attache de la boucle de détection au réseau d'alimentation. La base de données comprend en outre l'association entre la localisation sur la boucle de détection et chaque collier d'attache du réseau d'alimentation modélisé dans le modèle 3D. L'accès à cette information supplémentaire permet de faciliter la localisation de la fuite par l'opérateur.

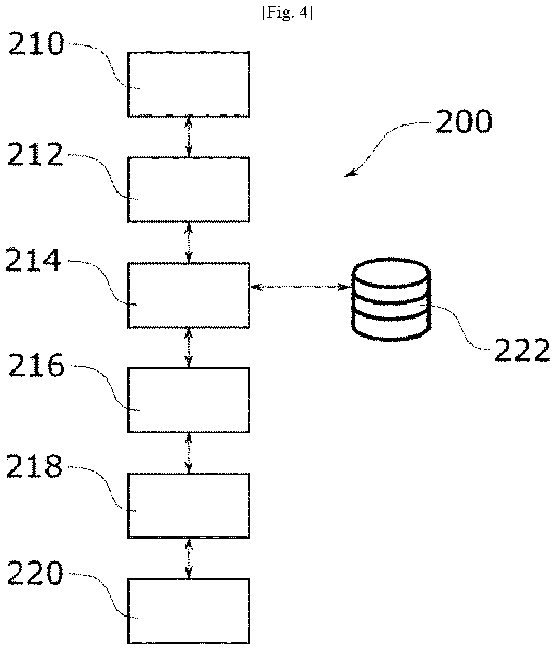

La figure 4 représente schématiquement un système 200 de localisation de fuite selon un mode de réalisation de l'invention, permettant de mettre en oeuvre l'ensemble ou une partie des étapes du procédé de localisation décrit précédemment.

Le système comprend notamment :
- un module 210 de réception d'une information représentative d'une détection de la fuite par un élément sensible de ladite boucle de détection, ladite information comprenant une référence à l'élément sensible ayant détecté la fuite et une localisation sur la boucle de détection,
- un module 212 de réception d'un modèle 3D d'au moins une partie du réseau d'alimentation en air pressurisé,
- un module 214 d'interrogation d'une base 222 de données associant un emplacement de fuite d'un composant du réseau d'alimentation à chaque localisation sur la boucle de détection,
- un module 216 de détermination, à partir de ladite information représentative d'une détection et de ladite base 222 de donnée, d'une localisation précise de ladite fuite sur le réseau d'alimentation en air pressurisé,
- un module 218 de mise en correspondance de ladite localisation précise relativement à un composant du réseau d'alimentation,
- un module 220 d'instructions d'affichage du modèle 3D correspondant audit composant du réseau d'alimentation et de ladite localisation précise

L'invention ne se limite pas aux modes de réalisation décrits. En particulier, le procédé de localisation de fuite peut être mis en oeuvre par un produit programme d'ordinateur embarqué par exemple dans un contrôleur de l'aéronef comprenant le réseau d'alimentation en air pressurisé, ou bien dans un dispositif informatique externe utilisé par les opérateurs de maintenance ou de réparation.

## Revendications

1. Procédé de localisation d'une fuite d'air dans un réseau d'alimentation en air pressurisé comprenant une pluralité de composants et au moins une boucle (10) de détection de fuite comprenant une pluralité d'éléments (12a,12b,12c) sensibles, comprenant :
- une étape (110) de réception d'une information représentative d'une détection de la fuite par un élément sensible de ladite boucle de détection, ladite information comprenant une référence à l'élément sensible ayant détecté la fuite et une localisation sur la boucle de détection,
- une étape (112) de réception d'un modèle 3D d'au moins une partie du réseau d'alimentation en air pressurisé,
- une étape (114) d'interrogation d'une base de données associant un emplacement de fuite d'un composant du réseau d'alimentation à chaque localisation sur la boucle de détection,
- une étape (116) de détermination, à partir de ladite information représentative d'une détection et de ladite base de donnée, d'une localisation précise de ladite fuite sur le réseau d'alimentation en air pressurisé,
- une étape (118) de mise en correspondance de ladite localisation précise relativement à un composant du réseau d'alimentation,
- une étape (120) d'instructions d'affichage du modèle 3D correspondant audit composant du réseau d'alimentation et de ladite localisation précise.

2. Procédé de localisation selon la revendication 1, **caractérisé en ce qu'**il comprend une étape (152) préliminaire de création de la base de données associant un emplacement de fuite d'un composant du réseau d'alimentation à chaque localisation sur la boucle de détection.

3. Procédé de localisation selon l'une des revendications 1 ou 2, **caractérisé en ce qu'**il comprend une étape (150) préliminaire de modélisation du modèle 3D, ledit modèle 3D comprenant des modèles 3D de composants du réseau d'alimentation et de la boucle de détection.

4. Procédé de localisation selon la revendication 3, **caractérisé en ce que** l'étape (150) préliminaire de modélisation du modèle 3D comprend la modélisation de colliers configurés pour l'attache de la boucle de détection au réseau d'alimentation.

5. Procédé de localisation selon la revendication 4, **caractérisé en ce que** la base de données comprend l'association entre la localisation sur la boucle de détection et chaque collier d'attache du réseau d'alimentation modélisé dans le modèle 3D.

6. Produit programme d'ordinateur pour la localisation d'une fuite d'air dans un réseau d'alimentation en air pressurisé comprenant une pluralité de composants et au moins une boucle (10) de détection de fuite comprenant une pluralité d'éléments (12a,12b,12c) sensibles, ledit produit programme d'ordinateur comprenant des instructions de code de programme pour l'exécution, lorsque ledit produit programme d'ordinateur est exécuté sur un ordinateur, des étapes suivantes :
- une étape (110) de réception d'une information représentative d'une détection de la fuite par un élément sensible de ladite boucle de détection, ladite information comprenant une référence à l'élément sensible ayant détecté la fuite et une localisation sur la boucle de détection,
- une étape (112) de réception d'un modèle 3D d'au moins une partie du réseau d'alimentation en air pressurisé,
- une étape (114) d'interrogation d'une base de données associant un emplacement de fuite d'un composant du réseau d'alimentation à chaque localisation sur la boucle de détection,
- une étape (116) de détermination, à partir de ladite information représentative d'une détection et de ladite base de donnée, d'une localisation précise de ladite fuite sur le réseau d'alimentation en air pressurisé,
- une étape (118) de mise en correspondance de ladite localisation précise relativement à un composant du réseau d'alimentation,
- une étape (120) d'instructions d'affichage du modèle 3D correspondant audit composant du réseau d'alimentation et de ladite localisation précise.

7. Système de localisation d'une fuite d'air dans un réseau d'alimentation en air pressurisé comprenant une pluralité de composants et au moins une boucle (10) de détection de fuite comprenant une pluralité d'éléments (12a,12b,12c) sensibles, comprenant :
- un module (210) de réception d'une information représentative d'une détection de la fuite par un élément sensible de ladite boucle de détection, ladite information comprenant une référence à l'élément sensible ayant détecté la fuite et une localisation sur la boucle de détection,
- un module (212) de réception d'un modèle 3D d'au moins une partie du réseau d'alimentation en air pressurisé,
- un module (214) d'interrogation d'une base (222) de données associant un emplacement de fuite d'un composant du réseau d'alimentation à chaque localisation sur la boucle de détection,
- un module (216) de détermination, à partir de ladite information représentative d'une détection et de ladite base (222) de donnée, d'une localisation précise de ladite fuite sur le réseau d'alimentation en air pressurisé,
- un module (218) de mise en correspondance de ladite localisation précise relativement à un composant du réseau d'alimentation,
- un module (220) d'instructions d'affichage du modèle 3D correspondant audit composant du réseau d'alimentation et de ladite localisation précise.
